(19) Europäisches Patentamt
European Patent Office
Office européen des brevets

(11) Veröffentlichungsnummer: **0 258 657 B1**

(12) **EUROPÄISCHE PATENTSCHRIFT**

(45) Veröffentlichungstag der Patentschrift: **05.08.92**

(51) Int. Cl.5: **H01L 27/10**, H01L 21/82

(21) Anmeldenummer: **87111193.6**

(22) Anmeldetag: **03.08.87**

(54) Transistorvaraktoranordnung für dynamische Halbleiterspeicher.

(30) Priorität: **22.08.86 DE 3628500**

(43) Veröffentlichungstag der Anmeldung:
**09.03.88 Patentblatt 88/10**

(45) Bekanntmachung des Hinweises auf die
Patenterteilung:
**05.08.92 Patentblatt 92/32**

(84) Benannte Vertragsstaaten:
**AT DE FR GB IT NL**

(56) Entgegenhaltungen:
**EP-A- 0 112 670**
**EP-A- 0 161 850**
**US-A- 4 356 040**

**IEEE TRANSACTIONS ON ELECTRON DEVICES, Band ED-29, Nr. 3, März 1982, Seiten 368-376, New York, US; K. OHTA et al.: "Ouadruply self-aligned stacked high-capacitance RAM using Ta2O5 high-density VLSI dynamic memory"**

(73) Patentinhaber: **SIEMENS AKTIENGESELL-SCHAFT**
**Wittelsbacherplatz 2**
**W-8000 München 2(DE)**

(72) Erfinder: **Küsters, Karl-Heinz, Dr.rer.nat.**
**Heinrich-Wieland-Strasse 71**
**W-8000 München 83(DE)**

**Beschreibung**

Die Erfindung betrifft eine Transistorvaraktoranordnung für dynamische Halbleiterspeicher auf einem dotierten Siliziumsubstrat.

Die Grundstruktur für die dynamischen Halbleiterspeicher auch DRAMs genannt, besteht aus einer Transistorvaraktorzelle. Der Transistor ist als MOS-FET konzipiert und ist über nach außen kontaktierte Source- und Gategebiete von außen steuerbar. Sein Draingebiet ist elektrisch mit einer Elektrodenseite des Varaktors verbunden, dessen zweite Elektrodenseite durch einen kontaktierten Anschluß von außen zu beeinflussen ist. Bei Pakkungsdichten von Transistoren- und Varaktoren im 1 Megabitbereich werden die Varaktoren meist planar ausgeführt, dies bedeutet, der Varaktor besteht aus einer dotierten Schicht des Siliziumsubstrats und einer planaren Polysiliziumschicht mit einer trennenden Dielektrikumsschicht. Zur Erhöhung der Packungsdichte bei dynamischen Speichern (DRAMs) sind aus Gründen der kleineren zur Verfügung stehenden Zellflächen und der aufgrund der Störsicherheit erforderlichen Kapazitätsgrößen von 30 bis 50 fF neue Überlegungen für die Ausgestaltung der Varaktoren notwendig. Eine Möglichkeit diese Forderungen, also verringerter Platzbedarf und eine Mindestkapazität des Varaktors, besteht in dem Konzept den Varaktor als "stacked capacitor" aufzubauen. Der "stacked capacitor" besteht aus zwei Polysiliziumschichten mit einer trennenden Dielektrikumsschicht, die nicht mehr planar ausgebildet sind, sondern die Gateelektrode des Feldeffekttransistors überlappen.

Es ist bekannt, daß mit dem Konzept des "stacked capacitor" der Integrationsgrad der dynamischen Halbleiterspeicher zu erhöhen ist, siehe IEEE Transaction on Electron Devices, Vol. ED-27, Nr. 8, August 1980, "A 5 V Only 16 kbit Stacked-Capacitor Mos Ram" von Mitsumasa Koyanagi, Yoshio Sakai, Masamichi Ishihara, Masanori Tazunoki und Norikazu Hashimoto (Seite 1596 bis Seite 1601). Ein "stacked capacitor" ist entsprechend dieser Veröffentlichung aus einer zweischichtigen Polysiliziumstruktur mit einer Siliziumnitridschicht $Si_3N_4$ (meist Poly Si-$Si_3N_4$-Poly Si oder Al) aufgebaut. In Figur 1 dieser Veröffentlichung werden drei "stacked capacitor" Zellstrukturen aufgeführt: A) "top capacitor", B) "intermediate capacitor" und C) "bottom capacitor". Bei den Ausführungsformen A und B werden die Gateelektroden von den "stacked capacitor" teilweise überlappt. Im Fall A ist die Dreischichtstruktur eine Poly Si-$Si_3N_4$-Al-Schicht im Fall B eine Poly Si-$Si_3N_4$ und wiederum eine Poly Si-Schicht. Im dritten Fall C dem "bottom capacitor" bedeckt die Gateelektrode teilweise den "stacked capacitor" der wiederum aus einer Poly Si-$Si_3N_4$-Poly Si-Struktur besteht.

In der Vergangenheit sind weitere verschiedene Zellstrukturen zur Erhöhung des Integrationsgrades gefunden worden, wie beispielsweise die CCB-Zelle (capacitance-coupled Bit Line Zelle). Das Konzept einer CCB-Zelle ist in der Veröffentlichung des IEEE Journal of Solid State Circuits, Volume SC-20, Nr. 1, "A Capacitance-Coupled Bit Line Cell" von Masao Taguchi, Satoshi Ando, Shimpei Hijiya, Tetsuo Nakamura, Seiji Enomoto und Takashi Yabu (Seite 210 bis Seite 215) aufgeführt. Der Grundgedanke dieser Zelle liegt in einem kapazitiv gekoppelten Anschluß des Source- oder Draingebietes. In Figur 1 dieser Veröffentlichung ist der Strukturaufbau näher erläutert, er besteht aus einer dreischichtigen Polysiliziumstruktur. Die erste Schicht bildet die Gateelektrode, die zweite und dritte Schicht den Varaktor mit einer trennenden Dielektrikumsschicht.

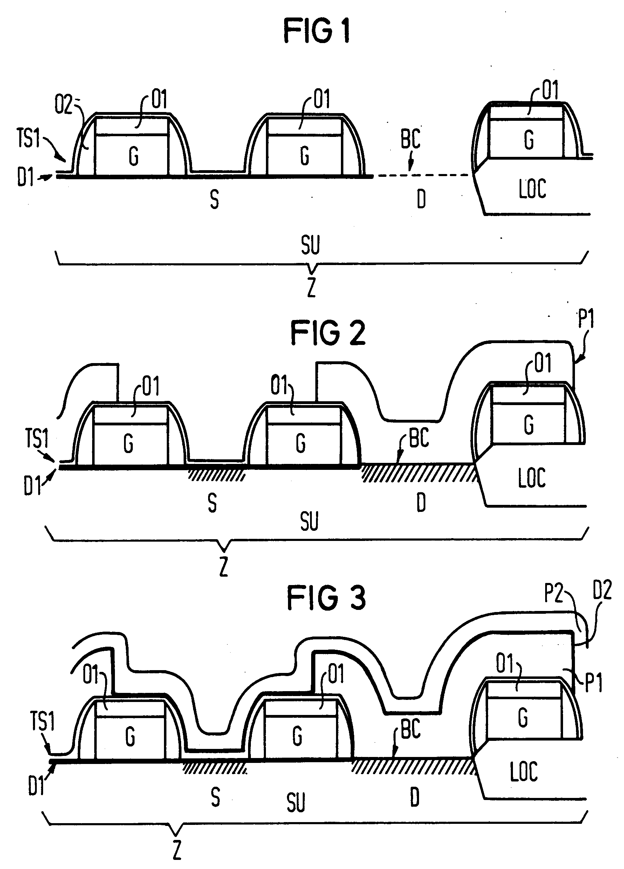

Eine andere Möglichkeit den Integrationsgrad zu erhöhen ist aus IEEE Electron Device Letters, Volume EDL-5, Nr. 5, May 1984, "A Three-Dimensional Folded Dynamic RAM in Beam-Recrystallized Polysilicon" von J. C. Sturm, M. D. Giles und J. F. Gibbons (Seite 151 bis Seite 153), bekannt. Hierbei wird die Transistorvaraktoranordnung dadurch komprimiert, daß ein Teil der einen Polysiliumschicht des Varaktors die andere u-förmig umfaßt und der Transistor über der zweiten Polysiliziumschicht des Varaktors angeordnet ist (siehe Figur 1 und Figur 2). Diese Anordnung wird auch als dynamische "folded" RAM-Zelle bezeichnet.

Weitere Möglichkeiten ergeben sich aus der Verwendung der "Hi-C" RAM-Zelle (high capacity RAM Zelle) siehe SZE, VLSI Technology, (Seite 476 - Seite 478). Es wird dabei eine Arsen und eine tiefer gehende Borimplantation unter dem Varaktor vorgenommen, um bei verringerten Zellflächen die Kapazität des Varaktors möglichst groß zu halten. Aufgrund der ausgeführten Implantationen ergibt sich eine zusätzlich ausgeprägte Sperrschichtkapazität, die die Ladungskapazität des Varaktors erhöht. Bei der Herstellung eines "stacked capacitor" in einer Transistorvaraktorzelle müssen bisher aufgrund von Justiertoleranzen der einzelnen Schichten zueinander und aufgrund der Maßhaltigkeit der Strukturübertragung gewisse Designabstände zwischen den verschiedenen Schichten eingehalten werden. Geschieht dies nicht, so besteht die Gefahr eines Kurzschlusses zwischen den Schichten. Beim Konzept der CCB Zelle besteht aufgrund der kapazitiven Ankopplung des Source oder Draingebiets die Gefahr einer Spannungsüberhöhung zwischen den Anschlüssen des Transistors in dem Augenblick, wo sich das Potential auf dem kapazitiven Anschlußkontakt verändert. Dies ist besonders kritisch bei Kanallängen von 0,7 bis 1 μm der Transistoren.

Die EP-A-0 112 670 betrifft einen Halbleiterspeicher mit stacked-capacitor-Zelle entsprechend dem Oberbegriff von Anspruch 1, bei dem die Varaktorelektroden die Gateelektrode des Auswahltransistors teilweise überlappen. Der Bitleitungskontakt ist in einigem Abstand von der Gateelektrode mit dem Sourceanschluß des Auswahltransistors verbunden. Der Abstand ist durch Justiertoleranzen und Designabstände bestimmt und erlaubt keine hohe Integrationsdichte. Die Ausführung der Kontakte wird nicht diskutiert.

Aus der EP-A-0 161 850 ist eine Anordnung bekannt, bei der die Varaktorelektroden die Gateelektrode des Auswahltransistors teilweise überlappen und der Bitleitungskontakt selbstjustierend bezüglich einer zusätzlichen leitenden Ebene mit sogenannten Poly-Inseln ist, die teilweise überlappend zur Gateelektrode sind. Der Kontakt ist nicht selbstjustierend zu den Varaktorelektroden. Die Strukturabmessungen sind durch den notwendigen Abstand der Varaktorelektroden zu den Poly-Inseln bestimmt sowie durch deren notwendigen Überlapp über die Gateelektrode. Der minimale Abstand ergibt sich durch die Auflösung der Lithographie. Die Poly-Inseln erhöhen die Layout-Komplexität und sind für die Erhöhung der Integrationsdichte nachteilig.

Der Erfindung liegt die Aufgabe zugrunde, durch ein Zellkonzept der Transistorvaraktoranordnung die Integrationsdichte zu erhöhen und durch ein einfaches Verfahren diese Transistorvaraktoranordnung herzustellen.

Diese Aufgabe wird erfindungsgemäß dadurch gelöst, daß eine Transistorvaraktoranordnung für dynamische Halbleiterspeicher auf einem dotierten Siliziumsubstrat verwendet wird, bestehend aus

- mindestens einem Feldeffekttransistor mit in dem dotierten Siliziumsubstrat liegenden Source- und Drain-Gebiet und einer allseitig mit Isolierschichten bedeckten Gateelektrode, dessen Sourcegebiet direkt durch einen Anschluß von außen kontaktierbar ist, und
- mindestens einem die Gateelektrode des Feldeffekttransistors überlappenden Varaktor, der als "stacked capacitor" ausgebildet ist, der aus zwei dotierten Polysiliziumschichten mit einer trennenden Dielektrikumsschicht besteht, wobei
- die obere Polysiliziumschicht von außen kontaktierbar ist und die untere Polysiliziumschicht und die Seitenflanken der unteren Polysiliziumschicht überlappt und die Gateelektrode zum größten Teil überlappt,
- zur Isolation der Seitenwände der oberen Polysiliziumschicht gegen den Anschluß zum Sourcegebiet eine durch Oxidation der Seitenwände der oberen Polysiliziumschicht erzeugte Oxidschicht vorgesehen ist,
- eine Isolationsschicht auf der oberen Polysiliziumschicht - ausgenommen deren Kontaktbereich - und auf der an den Seitenwänden der oberen Polysiliziumschicht befindlichen Oxidschicht vorgesehen ist,
- die untere Polysiliziumschicht die Gateelektrode teilweise überlappt und mit dem Draingebiet des Feldeffekttransistors verbunden ist und
- eine Nitrid und/oder Tetraethylorthosilikat enthaltende Schicht über der allseitig mit Isolierschichten bedeckten Gateelektrode vorgesehen ist.

Die Erfindung hat den Vorteil, daß der Bitleitungskontakt selbstjustierend zur Gateelektrode und zu den Varaktorelektroden ist. Deshalb kann der Bitleitungskontakt im Layout sowohl die Gateelektrode wie auch die obere Varaktorplatte überlappen. Im Querschnitt ist der Abstand des Bitleitungskontakts zur oberen Varaktorelektrode so gering wie eine minimale Oxidisolation. Damit hängen die Abmessungen nicht mehr von der Lithographie, sondern von der Prozeßführung bei der Ätzung des Bitleitungskontakts ab.

Um die Integrationsdichte zu erhöhen ist die untere Seite der Gateelektrode mit einer Dielektrikumschicht bedeckt und die anderen Seiten der Gateelektrode sind mit einer Siliziumoxidschicht bedeckt, weiterhin ist die Gateelektrode mit einer Nitrid, Teos (Tetraethylorthosilikat) oder Teos-Nitridschicht bedeckt.

Weitere Ausgestaltungen der Erfindung, insbesondere zu ihrer Realisierung ergeben sich aus den Unteransprüchen.

Die mit der Erfindung erzielten Vorteile bestehen insbesondere in einem Kapazitätsgewinn des Varaktors durch die größere Überlappungsflächen der zwei Polysiliziumschichten des Varaktors. Durch ein einfaches Herstellungsverfahren werden alle Designgrößen mit Ausnahme des Überlappungsabstandes der oberen und unteren Polysiliziumschicht des Varaktors unabhängig von den Justiertoleranzen der Phototechnik.

In den Figuren 1 bis 10 wird das Verfahren zur Herstellung der erfindungsgemäßen Transistorvaraktoranordnung näher beschrieben. Es zeigen dabei

Figur 1 bis 5     Schnitte durch ein Zellenfeld zum Verfahren der Transistorvaraktoranordnung und die

Figur 6 bis 10     Transistoren in dem Peripheriebereich, die gleichzeitig mit dem angegebenen Verfahren hergestellt werden.

Figur 1: Ausgangspunkt des Verfahrens bildet das Substratgebiet (SU). Hierauf werden, um die späteren aktiven Gebiete untereinander elektrisch zu trennen, Isolierschichten (LOG) mit Hilfe von örtlich gezielten lokalen Oxidationen LOCOS-Verfahren = local oxidation of silicon erzeugt. Auf dem Zellenfeld (Z) wird anschließend eine Dielektrikumsschicht (D1) aufgetragen und die Gateelektroden (G) der Feldeffekttransistoren aus einer dotierten Polysiliziumschicht an den gewünschten Stellen erzeugt. Über der Polysiliziumschicht der Gateelektroden (G) wird eine Oxidschicht (O1) abgeschieden, die zusammen mit den Gateelektroden (G) strukturiert wird.

Da aufgrund der Erhöhung der Integrationsdichte die Gateelektroden (G) allseitig von Isolierschichten umgeben sein sollen werden nun mit Hilfe der Spacertechnik (Abscheidung von Siliziumoxid ganzflächig und anisotropes Zurückätzen, das heißt, an den Seitenflanken bleibt Oxid stehen) die Seitenflächen (O2) mit einem Oxidmantel eingekapselt. Mit Hilfe eines CVD (chemical vapour deposition = Abscheidung aus der Gasphase)-Prozesses wird über dem gesamten Zellenfeld (Z) einschließlich der allseitig isolierten Gateelektroden (G) eine dünne Teos (Tetraethylorthosilikat), Nitrid oder Teos/Nitridschicht (TS1) abgeschieden. Diese Schicht dient im weiteren Verfahrensablauf dazu, die zweite noch aufzubringende Polysiliziumschicht durch einen Ätzvorgang zu strukturieren ohne in die Sourcegebiete des Zellenfeldes, die nicht mit der zweiten Polysiliziumschicht bedeckt werden sollen hineinzuätzen. Die Teos (Tetraethylorthosilikat), Nitrid oder Teos/Nitridschicht (TS1) wird dort entfernt, wo die zweite noch zu erzeugende Polysiliziumschicht elektrisch Kontakt zum Substrat (SU) des Zellenfeldes (Z) haben soll. Dieser Bereich wird auch als "buried contact" (BC) bezeichnet, da er nach außen keine Anschlußmöglichkeit mehr besitzt. Dabei wird zugelassen, daß die Teos, Nitrid oder Teos/Nitridschicht (TS1) auch an den am "buried contact" (BC) angrenzenden Gebieten entfernt wird, so daß auch bei einer Dejustierung der Phototechnik, die den "buried contact" (BC) herstellt, die spätere Kontaktfläche ganz freigeätzt wird.

Figur 2: Auf die Teos (Tetraethylorthosilikat), Nitrid oder Teos/Nitridschicht (TS1) des Zellenfeldes (Z) wird eine Polysiliziumschicht (P1) abgeschieden, die später jeweils die untere Elektrode des Varaktors bildet. Durch eine flache Implantation oder durch ein anderes Dotierungsverfahren wird diese Polysiliziumschicht (P1) leitfähig gemacht und anschließend so strukturiert, daß die Gateelektrode des Feldeffekttransistors teilweise überdeckt wird. Zur Leitfähigkeit von Source-(S) und Drain (D)-Gebiet des Feldeffekttransistors wird das Source-Gebiet (S) im Zellenfeld, das sich zwischen den Gateelektroden (G) befindet durch eine Implantation oder ein anderes Dotierungsverfahren und das Draingebiet (D) unter dem "buried contact" (BC) durch Ausdiffusion der dotierten Polysiliziumschicht (P1) dotiert.

Figur 3: Im nächsten Verfahrensschritt, wird die zwischen der dotierten Polysiliziumschicht (P1) und der im weiteren Verfahrensablauf aufzubringenden Polysiliziumschicht (P2) des Varaktors erforderliche Dielektriumsschicht (D2) durch einen Oxidationsvorgang oder durch einen CVD ( = chemical vapour deposition = Abscheidung aus der Gasphase)-Prozeß über das gesamte Zellenfeld (Z) abgeschieden. Es wird anschließend über das gesamte Zellenfeld (Z) eine zweite Polysiliziumschicht (P2) abgeschieden und mit einem Dotierungsverfahren dotiert. Die dotierte Polysiliziumschicht (P2) bildet nach ihrer Strukturierung in einem späteren Verfahrensschritt zusammen mit der Dielektrikumsschicht (D2) und der dotierten Polysiliziumschicht (P1) den Varaktor, der aufgrund seiner Bauform auch als "stacked capacitor" bezeichnet wird.

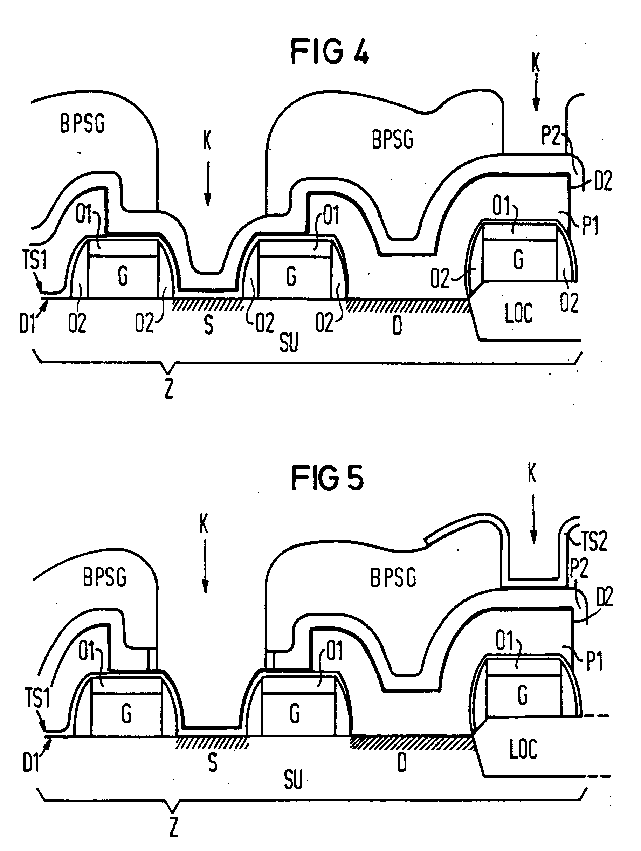

Figur 4: Im weiteren Verfahrensablauf wird über einen CVD ( = chemical vapour deposition = Abscheidung aus der Gasphase)-Prozeß eine Teos (Tetraethylorthosilikat) und eine Bor-Phosphor-Silikatglasschicht (BPSG) als Isolationsschicht abgeschieden, wobei die Bor-Phosphor-Silikatglasschicht (BPSG) dazu dient, die auf dem Zellenfeld (Z) durch die bisherigen Verfahrensschritte entstandenen Kantenstrukturen für die abschließende Anschlußmetallisierung abzurunden. Die Isolationsschicht (BPSG) wird im Bereich der Anschlußkontakte (K) wieder entfernt. Das Kontaktloch für den Anschlußkontakt (K) zum Sourcegebiet (S) darf dabei über die Gateelektrode (G) überlappen, es kann größer sein als die spätere Kontaktfläche zum Sourcegebiet (S). Auch bei einer Dejustierung der Phototechnik, die den Anschlußkontakt K herstellt, kann deshalb die ganze Fläche zwischen den Oxidseitenflächen (02) der Gateelektroden (G) als Kontaktfläche genutzt werden.

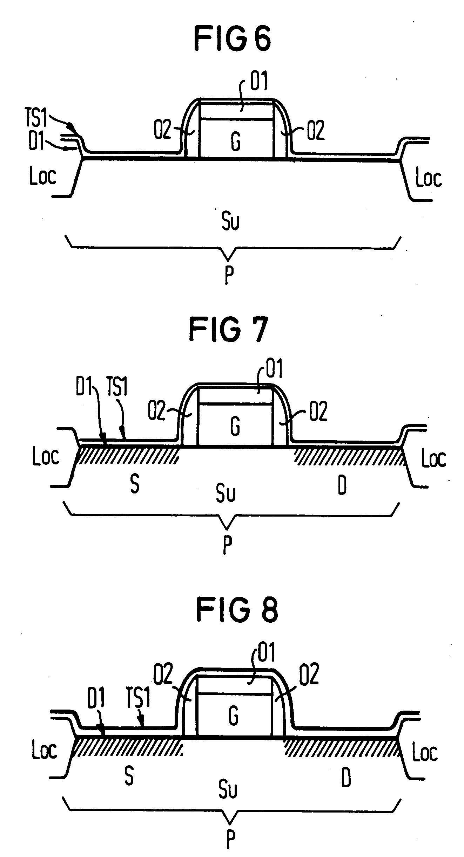

Figur 5: Für den nachfolgenden Ätzvorgang der dotierten Polysiliziumschicht (P2) im Bereich des späteren Anschlußkontaktes (K) über dem Sourcegebiet (S) wird über das Zellenfeld (Z) eine weitere Teos, Nitrid oder TeosNitridschicht (TS2) durch einen CVD-Prozeß abgeschieden und über einen isotropen Ätzvorgang über dem späteren Anschlußkontakt (K) des Sourcegebietes (S) entfernt. Nun kann in einem weiteren Ätzvorgang die dotierte Polysiliziumschicht (P2) im Bereich des Anschlußkontaktes (K) des Sourcegebietes (S) entfernt werden ohne die übrige Polysiliziumschicht (P2) zu beschädigen. Der Ätzvorgang stoppt ausschließlich auf der Dielektrikumsschicht (D1) und der Teos-Nitridschicht (TS1). Damit die obere dotierte Poliumsiliziumschicht (P2) nicht elektrisch mit dem Anschlußkontakt (K) des Sourcegebietes (S) verbunden ist, werden die Flanken der oberen dotierten Polysiliziumschicht (P2) in den Bereich des späteren Anschlußkontaktes (K) des Sourcegebietes (S) aufoxidiert. Eine Aufoxidation des Source Diffusionsgebietes (S) bei diesem Verfahrensschritt wird durch die Teos, Nitrid oder Teos/Nitridschicht (TS1) bzw. die Dielektrikumsschicht (D1) verhindert. Durch eine kurze anisotrope Ätzung wird anschließend die Teos (Tetraethylorthosilikat), Nitrid oder Teos-Nitridschicht (TS2) selbst und ein evtl. dünnes Oxid darauf entfernt. Noch vorhandene Restoxide im Bereich der Anschlußkontakte (K) werden weggeätzt und abschließend die Anschlußkontakte (K) metallisiert.

Figur 6: Alle Verfahrensschritte in Figur 1 bis auf den letzten werden ebenfalls hier durchgeführt. Da der Peripheriebereich (P) keinen "stacked capacitor" aufweist, ist auch kein "buried contact" (BC) erforderlich und die Teos (Tetraethylorthosilikat), Nitrid oder Teos/Nitridschicht (TS1) bildet eine geschlossene Oberfläche über dem Peripheriebereich (P).

Figur 7: Die Verfahrensschritte entsprechen mit folgenden Ausnahmen denen in Figur 2. Da in dem Peripherierbereich (P) kein Varaktor untergebracht ist, kann die dotierte Polysiliziumschicht (P1) hier wieder ganz entfernt werden. Statt einer Ausdiffusion der dotierten Polysiliziumschicht (P1), die in Figur 1 zur Dotierung des Draingebietes (D) diente wird das Sourcegebiet (S) und Draingebiet (D) gemeinsam durch ein Dotierungsverfahren wie zum Beispiel einer Implantation dotiert.

Figur 8: Die in Figur 8 durchgeführten Verfahrensschritte, entsprechen wiederum denen in Figur 3, jedoch wird die dotierte Polysiliziumschicht (P2) für den Varaktor ebenso wie die Teos (Tetraethylorthosilikat), Nitrid oder Teos/Nitridschicht (TS1) und die Dielektrikumsschicht (D1) im Bereich des Source (S) und Draingebietes (D) entfernt.

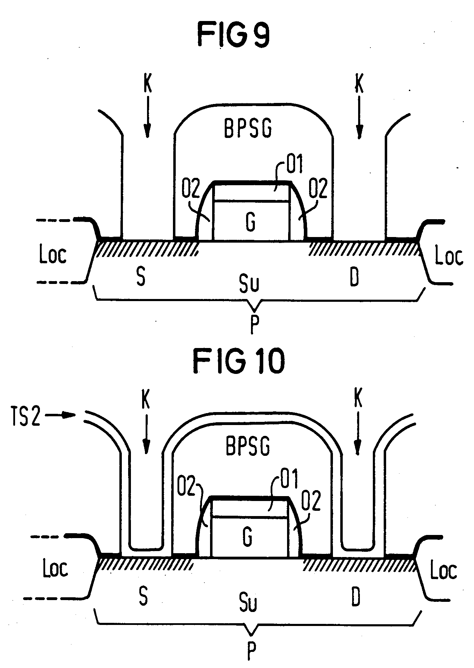

Figur 9: Im weiteren Verfahrensablauf wird mit Hilfe eines CVD (= chemical vapour deposition = Abscheidung aus der Gasphase)-Prozesses eine Teos (Tetraethylorthosilikat) und eine Bor-Phosphor-Silikatglasschicht (BPSG) als Isolationsschicht abgeschieden und in den Bereichen der späteren Anschlußkontakte (K) für das Source (S) und Drain (D)-Gebiet wieder entfernt.

Figur 10: Für den nachfolgenden Ätzvorgang der dotierten Polysiliziumschicht (P2) über dem Sourcegebiet (S) des Zellenfeldes (Z) in Figur 5 wird über dem Peripheriebereich (P) eine weitere Teos (Tetraethylorthosilikat), Nitrid oder Teos-Nitridschicht (TS2) durch einen CVD (= chemical vapour deposition = Abscheidung aus der Gasphase)-Prozeß abgeschieden. Diese Schicht verhindert eine Aufoxidation des Source-Drain-Diffusionsgebietes (S, D) in den Anschlußkontakten (K) bei der Oxidation zur Isolation der Flanken der Polysiliziumschicht (P2) in Figur 5. Durch eine kurze anisotrope Ätzung wird anschließend die Teos (Tetraethylorthosilikat), Nitrid oder Teos/Nitridschicht (TS2) selbst und ein eventuell dünnes Oxid auf dieser entfernt. Vorhandene Restoxide im Bereich der späteren Anschlußkontakte (K) des Source (S) und Drainbereichs (D) in der Peripherie (P) werden weggeätzt und abschließend die Anschlußkontakte (K) metallisiert.

**Patentansprüche**

1. Transistorvaraktoranordnung für dynamische Halbleiterspeicher auf einem dotierten Siliziumsubstrat (SU) bestehend aus:
   mindestens einem Feldeffekttransistor mit in dem dotierten Siliziumsubstrat liegenden Source (S)- und Drain (D)-Gebiet und einer allseitig mit Isolierschichten bedeckten Gateelektrode (G), dessen Sourcegebiet (S) direkt durch einen Anschluß (K) von außen kontaktierbar ist, und
   mindestens einem die Gateelektrode (G) des Feldeffekttransistors überlappenden Varaktor, der als "stacked capacitor" ausgebildet ist, der aus zwei dotierten Polysiliziumschichten (P1, P2) mit einer trennenden Dielektrikumsschicht (D2) besteht, wobei
   die obere Polysiliziumschicht (P2) die untere Polysiliziumschicht (P1) und die Seitenflanken der unteren Polysiliziumschicht (P1) überlappt und die Gateelektrode (G) zum größten Teil überlappt,
   eine Isolationsschicht (BPSG) auf der oberen Polysiliziumschicht (P2) - ausgenommen deren Kontaktbereich (K) - vorgesehen ist,
   die untere Polysiliziumschicht (P1) die Gateelektrode (G) teilweise überlappt und mit dem Draingebiet (D) des Feldeffekttransistors verbunden ist
   dadurch gekennzeichnet, daß die obere Polysiliziumschicht (P2) von außer kontaktierbar ist,
   daß zur Isolation der Seitenwände der oberen Polysiliziumschicht (P2) gegen den Anschluß (K) zum Sourcegebiet (S) eine durch Oxidation der Seitenwände der oberen Polysiliziumschicht (P2) erzeugte Oxidschicht vorgesehen ist,
   daß die Isolationsschicht (BPSG) auch auf der an den Seitenwänden der oberen Polysiliziumschicht (P2) befindlichen Oxidschicht vorgesehen ist,
   und daß eine Nitrid und/oder Tetraethylorthosilikat enthaltende Schicht (TS1) über der allseitig mit Isolierschichten (01, 02) bedeckten Gateelektrode (G) vorgesehen ist.

2. Transistorvaraktoranordnung nach Anspruch 1, **dadurch gekennzeichnet,** daß das Kontaktloch (K) für den Anschluß zum Sourcegebiet (S) die Gateelektrode (G) überlappt.

3. Transistorvaraktoranordnung nach Anspruch 1, **dadurch gekennzeichnet,** daß die Poly-Si-Schicht der Gateelektrode (G) mit einer Siliziumoxidschicht (01, 02) bedeckt ist.

4. Transistorvaraktoranordnung nach Anspruch 3, **dadurch gekennzeichnet,** daß die mit Oxidschichten (01, 02) eingekapselte Gateelektrode (G) mit einer Nitrid-, Teos- oder einer Teos-Nitrid-Schicht (TS1) bedeckt ist.

5. Verfahren zum Herstellen einer Transistorvaraktoranordnung nach einem der Ansprüche 1 bis 4, **gekennzeichnet** durch den Ablauf der folgenden Schritte:

    a) es wird durch einen CVD (= chemical vapour deposition = Ausscheidung aus der Gasphase)-Prozeß über einem Zellenfeld mit allseitig isolierten Gateelektroden (G) mit Source- (S) und Drain (D)-Gebieten (Z) eine Teos-(= Tetraethylorthosilikat), Nitrid- oder eine Teos-Nitridschicht (TS1) abgeschieden und es wird die abgeschiedene Schicht (TS1) über dem Bereich des geplanten Draingebiets (D) des Feldeffekttransistors entfernt, um einen buried contact (BC) zwischen dem geplanten Draingebiet (D) und dem geplanten Varaktor herzustellen,

    b) es wird eine erste Polysiliziumschicht (P1) über dem Zellenfeld (Z) aufgetragen,

    c) es wird die erste Polysiliziumschicht (P1) so strukturiert, daß sie die Gateelektrode (G) des Feldeffekttransistors teilweise überdeckt,

    d) es wird durch eine Oxidation oder einen CVD-Prozeß über dem Zellenfeld (Z) eine Dielektrikumsschicht (D2) abgeschieden,

    e) es wird eine zweite Polysiliziumschicht (P2) über dem Zellenfeld (Z) aufgetragen,

    f) es wird durch einen CVD-Prozeß eine Bor-Phosphor-Silikatglasschicht (BPSG) abgeschieden,

    g) es wird über Anschlußkontakten (K) die Bor-Phosphor-Silikatglasschicht (BPSG) entfernt,

    h) es wird durch einen CVD-Prozeß über dem Zellenfeld (Z) eine dünne Teos-, Nitrid- oder Teos-Nitridschicht (TS2) abgeschieden, die durch Ätzung im Bereich des Sourcegebiets (S) des Feldeffekttransistors entfernt wird,

    i) es wird im Bereich des Sourcegebiets (S) des Feldeffekttransistors die Polysiliziumschicht (P2) durchgeätzt, die Ätzung stoppt auf der Dielektrikums-(D1, D2) und der Teos-, Nitrid- oder Teos-Nitridschicht (TS1),

    j) es werden die Flanken der oberen dotierten Polysiliziumschicht (P2) im Bereich des Sourcegebiets (S) des Feldeffekttransistors aufoxidiert, um eine Isolation zwischen dem Anschlußkontakt (K) zum Sourcegebiet (S) und der oberen Polysiliziumschicht (P2) zu erzielen,

    k) es wird durch eine anisotrope Ätzung die Teos-, Nitrid- oder Teos-Nitridschicht (TS1, TS2) entfernt,

    l) es wird eine Rest-Oxidationsschicht im Bereich der Anschlußkontakte (K) weggeätzt,

    m) es werden die Anschlußkontakte (K) hergestellt.

6. Verfahren zum Herstellen einer Transistorvaraktoranordnung nach Anspruch 5, **dadurch gekennzeichnet,** daß im Verfahrensschritt g) Kontaktlöcher in die Teos (= Tetraethylorthosilika) und Phosphor-Silikatglasschicht (BPSG) geätzt werden, die die Gateelektroden (G) überlappen dürfen.

7. Verfahren zum Herstellen einer Transistorvaraktoranordnung nach Anspruch 5 oder 6, **dadurch gekennzeichnet,** daß zwischen Verfahrensschritt c) und d) das Sourcegebiet (S) des Feldeffekttransistors im Zellenfeld (Z) implantiert wird und durch Ausdiffusion der unteren dotierten Polysiliziumschicht (P1) des Varaktors das Draingebiet (D) des Feldeffekttransistors im Zellenfeld (Z) erzeugt wird.

8. Verfahren zum Herstellen einer Transistorvaraktoranordnung nach Anspruch 5 oder 6, **dadurch gekennzeichnet,** daß zwischen Verfahrensschritt a) und b) das Soruce (S) und Drain (D)-Gebiet des Feldeffekttransistors im Zellenfeld (Z) implantiert wird.

9. Verfahren zum Herstellen einer Transistorvaraktoranordnung nach Anspruch 5 oder 6, **dadurch gekennzeichnet,** daß zwischen Verfahrensschritt k) und l) das Sourcegebiet (S) des Feldeffekttransistors im Zellenfeld (Z) implantiert wird und durch Ausdiffusion der unteren dotierten Polysiliziumschicht (P1) des Varaktors das Draingebiet (D) des Feldeffekttransistors im Zellenfeld (Z) erzeugt wird.

10. Verfahren nach einem der Ansprüche 5 bis 8, **dadurch gekennzeichnet,** daß die erste und die zweite Polysiliziumschicht (P1, P2) jeweils nach ihrem Auftragen durch eine Implantation oder ein anderes Dotierungsverfahren dotiert werden.

**Claims**

1. Transistor-varactor arrangement for dynamic semiconductor memories on a doped silicon substrate (SU) comprising:

    at least one field-effect transistor which has a source region (S) and a drain region (D) situated in the doped silicon substrate and a gate electrode (G) covered on all sides with insulating layers and whose source region (S) can be contacted directly from the outside by a contact (K), and

    at least one varactor which overlaps the gate electrode (G) of the field-effect transistor and which is designed as a "stacked capacitor" which comprises two doped polysilicon layers (P1, P2) having an isolating dielectric layer (D2),

    the upper polysilicon layer (P2) overlapping the lower polysilicon layer (P1) and the side walls of the lower polysilicon layer (P1) and, for the most part, overlapping the gate electrode (G)

    an insulation layer (BPSG) being provided on the upper polysilicon layer (P2), with the exception of its contact region (K),

    the lower polysilicon layer (P1) partially overlapping the gate electrode (G) and being connected to the drain region (D) of the field-effect transistor,

    characterised in that the upper polysilicon layer (P2) can be contacted from the outside,

    in that, to insulate the side walls of the upper polysilicon layer (P2) from the connection (K) to the source region (S), an oxide layer is provided which is produced by oxidation of the side walls of the upper polysilicon layer (P2),

    in that the insulation layer (BPSG) is also provided on the oxide layer situated at the side walls of the upper polysilicon layer (P2),

    and in that a layer (TS1) containing nitride and/or tetraethyl orthosilicate is provided on top of the gate electrode (G) covered on all sides with insulating layers (01, 02).

2. Transistor-varactor arrangement according to Claim 1, characterised in that the via (K) for the connection to the source region (S) overlaps the gate electrode (G).

3. Transistor-varactor arrangement according to Claim 1, characterised in that the poly-Si layer of the gate electrode (G) is covered with a silicon oxide layer (01, 02).

4. Transistor-varactor arrangement according to Claim 3, characterised in that the gate electrode (G) encapsulated with oxide layers (01, 02) is covered with a nitride, Teos, or a Teos/nitride layer (TS1).

5. Process for producing a transistor-varactor arrangement according to one of Claims 1 to 4, characterised by the sequence of the following steps:

    a) a Teos (= tetraethyl orthosilicate), nitride or Teos/nitride layer (TS1) is deposited by a CVD (= chemical vapour deposition from the gas phase) process on top of a cell array (Z) comprising gate electrodes (G) insulated on all sides and having source (S) and drain (D) regions, and the layer deposited (TS1) on top of the area of the planned drain region (D) of the field-effect transistor is removed in order to produce a buried contact (BC) between the planned drain region (D) and the planned varactor,

    b) a first polysilicon layer (P1) is applied on top of the cell array (Z),

    c) the first polysilicon layer (P1) is structured in such a way that it partially overlaps the gate electrode (G) of the field-effect transistor,

    d) a dielectric layer (D2) is deposited on top of the cell array (Z) by an oxidation or CVD process,

    e) a second polysilicon layer (P2) is applied on top of the cell array (Z),

    f) a borophosphosilicate glass layer (BPSG) is deposited by a CVD process,

    g) the borophosphosilicate glass layer (BPSG) is removed above connection contacts (K),

    h) a thin Teos, nitride or Teos/nitride layer (TS2), which is removed by etching in the area of the source region (S) of the field-effect transistor, is deposited on top of the cell array (Z) by a CVD process,

    i) the polysilicon layer (P2) is etched through in the area of the source region (S) of the field-effect transistor, the etching stopping at the dielectric layer (D1, D2) and the Teos, nitride or Teos/nitride layer (TS1),

    j) the walls of the upper doped polysilicon layer (P2) are oxidised in the area of the source region (S) of the field-effect transistor in order to obtain insulation between the connection contact (K) to the source region (S) and the upper polysilicon layer (P2),

    k) the Teos, nitride or Teos/nitride layer (TS1, TS2) is removed by anisotropic etching,

    l) a residual oxidation layer is etched away in the area of the connection contacts (K),

    m) the connection contacts (K) are produced.

6. Process for producing a transistor-varactor arrangement according to Claim 5, characterised in that, in the process step g), vias which may overlap the gate electrodes (G) are etched in the Teos (= tetraethyl orthosilicate) and borophosphosilicate glass layer (BPSG).

7. Process for producing a transistor-varactor arrangement according to Claim 5 or 6, characterised in that, between process steps c) and d), the source region (S) of the field-effect transistor is implanted in the cell array (Z) and the drain region (D) of the field-effect transistor is produced in the cell array (Z) by outdiffusion of the lower doped polysilicon layer (P1) of the varactor.

8. Process for producing a transistor-varactor arrangement according to Claim 5 or 6, characterised in that, between process steps a) and b), the source (S) and drain (D) region of the field-effect transistor is implanted in the cell array (Z).

9. Process for producing a transistor-varactor arrangement according to Claim 5 or 6, characterised in that, between process steps k) and l), the source region (S) of the field-effect transistor is implanted in the cell array (Z) and the drain region (D) of the field-effect transistor is produced in the cell array (Z) by outdiffusion of the lower doped polysilicon layer (P1) of the varactor.

10. Process according to one of Claims 5 to 8, characterised in that the first and the second polysilicon layer (P1, P2) are each doped after their application by an implantation or another doping process.

**Revendications**

1. Dispositif transistor-varactor pour des mémoires dynamiques à semiconducteurs sur un substrat en silicium dopé (SU) constitué par au moins un transistor à effet de champ comportant une zone de source (S) et de drain (D) située dans le substrat en silicium dopé et une électrode de grille (G) recouverte de tous côtés par des couches isolantes, et dont la zone de source (S) peut être raccordée directement de l'extérieur au moyen d'une borne (K), et au moins un varactor qui chevauche l'électrode de grille (G) du transistor à effet de champ et qui, est agencé sous la forme d'un "stacked capacitor", qui est constitué par deux couches de polysilicium dopé (P1,P2) avec une couche diélectrique de séparation (D2),

la couche supérieure de polysilicium (P2) chevauchant la couche inférieure de polysilicium (P1) et les flancs latéraux de la couche inférieure de polysilicium (P1) et chevauchant en majeure partie l'électrode de grille (G), et une couche isolante (BPSG) étant prévue sur la couche supérieure de polysilicium (P2) -à l'exception de sa zone de contact (K),

la couche inférieure de polysilicium (P1) chevauchant partiellement l'électrode de grille (G) et étant raccordée à la zone de drain (D) du transistor à effet de champ,

caractérisé par le fait qu'un contact peut être établi de l'extérieur avec la couche supérieure de polysilicium (P2),

que pour l'isolation des parois latérales de la couche supérieure de polysilicium (P2) vis-à-vis de la borne (K) raccordée à la zone de source (S), il est prévu une couche d'oxyde produite par oxydation des parois latérales de la couche supérieure de polysilicium (P2), que la couche isolante (BPSG) est également prévue sur la couche d'oxyde située sur les parois latérales de la couche supérieure de polysilicium (P2),

et qu'une couche (TS1) contenant un nitrure et/ou un orthosilicate de tétraéthyle est prévue sur l'électrode de grille (G) recouverte de tous côtés par des couches isolantes (01,02).

2. Dispositif transistor-varactor suivant la revendication 1, caractérisé par le fait que le trou de contact (K) pour la borne de raccordement à la zone de source (S) chevauche l'électrode de grille (G).

3. Dispositif transistor-varactor suivant la revendication 1, caractérisé par le fait que la couche de polysilicium de l'électrode de grille (G) est recouverte par une couche d'oxyde de silicium (01,02).

4. Dispositif transistor-varactor suivant la revendication 3, caractérisé par le fait que l'électrode de grille (G) encapsulée par des couches d'oxyde (01,02) est recouverte par une couche (TS1) de nitrure, de Teos ou d'une couche de Teos-nitrure.

5. Procédé pour fabriquer un dispositif transistor-varactor suivant l'une des revendications 1 à 4, caractérisé par l'exécution des étapes suivantes :

a) au moyen d'un processus CVD (= chemical vapour deposition = dépôt chimique en phase vapeur), on dépose au-dessus d'une zone de cellule comportant des électrodes de grille (G) isolées de tous côtés et possédant des zones (Z) de source (S) et de drain (D), une couche de Teos (= orthosilicate de tétraéthyle), une couche de nitrure ou une couche de Teos-nitrure (TS1), et au-dessus de la zone projetée pour former la zone de drain (D) du transistor à effet de champ, on élimine la couche déposée de manière à établir un contact enseveli (BC) entre la zone de drain prévue (D) et le varactor prévu,

b) on dépose une première couche de polysilicium (P1) au-dessus de la zone de cellule (Z),

c) on structure la première couche de polysilicium (P1) de manière qu'elle recouvre partiellement l'électrode de grille (G) du transistor à effet de champ,

d) on dépose une couche diélectrique (D2) au-dessus de la zone de cellule (Z) au moyen d'une oxydation ou d'un procédé CVD,

e) on dépose une seconde couche de polysilicium (P2) au-dessus de la zone de cellule (Z),

f) on dépose une couche de verre au borophosphosilicate (BPSG) au moyen d'un procédé CVD,

g) on élimine la couche de verre au borophosphosilicate (BPSG) au-dessus de contacts de raccordement (K),

h) on dépose, au moyen d'un procédé CVD, au-dessus de la zone de cellule (Z), une couche mince de Teos, de nitrure, ou de Teos-nitrure (TS2), qu'on élimine par corrosion au niveau de la zone de source (S) du transistor à effet de champ,

i) on élimine complètement par corrosion la couche de polysilicium (P2) dans la région de la zone de source (S) du transistor à effet de champ et on arrête la corrosion au niveau de la couche de diélectrique (D1,D2) et de la couche de Teos, de nitrure, ou de Teos-nitrure (TS1),

j) on oxyde les flancs de la couche supérieure dopée de polysilicium (P2) au niveau de la zone de source (S) du transistor à effet de champ, pour obtenir une isolation entre le contact de raccordement (K) et la zone de source (S) et la couche supérieure de polysilicium (P2),

k) on élimine, au moyen d'une corrosion anisotrope, la couche de Teos, la couche de nitrure ou la couche de Teos-nitrure (TS1,TS2),

l) on élimine par corrosion une couche d'oxydation résiduelle au niveau des contacts de raccordement (K),

m) on forme les contacts de raccordement (K).

6. Procédé pour fabriquer un dispositif transistor-varactor suivant la revendication 5, caractérisé par le fait que lors de l'étape opératoire g), on aménage par corrosion des trous de contact dans la couche de Teos (= orthosilicate de tétraéthyle) et dans la couche de verre au phosphosilicate (BPSG), qui peuvent recouvrir les électrodes de grille (G).

7. Procédé pour fabriquer un dispositif transistor-varactor suivant la revendication 5 ou 6, caractérisé par le fait qu'entre les étapes opératoires c) et d), on implante la zone de source (S) du transistor à effet de champ dans la zone de cellule (Z) et on forme, par diffusion de la couche inférieure de polysilicium dopée (P1) du varactor la zone de drain (D) du transistor à effet de champ dans la zone de cellule (Z).

8. Procédé pour fabriquer un dispositif transistor-varactor suivant la revendication 5 ou 6, caractérisé par le fait qu'entre les étapes opératoires a) et b), on implante la zone de source (S) et la zone de drain (D) du transistor à effet de champ dans la zone de cellule (Z).

9. Procédé pour fabriquer un dispositif transistor-varactor suivant la revendication 5 ou 6, caractérisé par le fait qu'entre les étapes opératoires k) et l), on implante la zone de source (S) du transistor à effet de champ dans la zone de cellule (Z) et on forme, par diffusion de la couche inférieure dopée de polysilicium (P1) du varactor, la zone de drain (D) du transistor à effet de champ, dans la zone de cellule.

10. Procédé suivant l'une des revendications 5 à 8, caractérisé par le fait qu'on dope les première et seconde couches de polysilicium (P1,P2) respectivement après leur dépôt, au moyen d'une implantation ou d'un autre procédé de dopage.

## FIG 1

## FIG 2

## FIG 3

## FIG 4

## FIG 5

# FIG 6

# FIG 7

# FIG 8

EP 0 258 657 B1

# FIG 9

# FIG 10